# EUROPEAN PATENT SPECIFICATION

(11) **EP 2 520 943 B1**
(45) Date of publication and mention of the grant of the patent: **28.10.2020**
(21) Application number: 10841202.4
(22) Date of filing: 24.12.2010
(51) Int. Cl.: G01R 31/12, G01R 31/40, H01Q 9/40

(54) **APPARATUS FOR DETECTING PARTIAL DISCHARGE FOR ELECTRIC POWER DEVICES**
VORRICHTUNG ZUR DETEKTION DER TEILENTLADUNG FÜR ELEKTRISCHE LEISTUNGSVORRICHTUNGEN
APPAREIL POUR DÉTECTER UNE DÉCHARGE PARTIELLE POUR DES DISPOSITIFS ÉLECTRIQUES DE PUISSANCE

(30) Priority: 28.12.2009 KR 20090132198
(43) Date of publication of application: 07.11.2012
(73) Proprietor: Hyosung Heavy Industries Corporation, Seoul 04144 (KR)
(72) Inventor: LYU, Eun Tae, Anyang-si Gyeonggi-do 431-830 (KR); HWANG, Kyung Rok, Anyang-si Gyeonggi-do 431-830 (KR); KIM, Min Soo, Anyang-si Gyeonggi-do 431-830 (KR); YANG, Hang Jun, Anyang-si Gyeonggi-do 431-830 (KR)
(74) Representative: Viering, Jentschura & Partner mbB Patent- und Rechtsanwälte
(86) International application number: PCT/KR2010/009330
(87) International publication number: WO 2011/081370

(56) References cited:
- EP-A1- 0 699 918
- JP-A- 5 002 048
- JP-A- 2002 508 520
- JP-A- 2008 082 904
- KR-A- 20100 090 012
- US-A- 5 726 576
- US-A1- 2005 285 604
- US-A1- 2006 145 705
- US-B1- 6 333 715

## Description

### Technical Field

The present invention relates to an apparatus for detecting partial discharge for an electric power device, and more particularly, to a partial discharge detecting apparatus for an electric power device that may measure signals of multiple frequency bands in which the electric power device may correspond to a power transformer and the electric power device may include a rotary device, a motor, a generator, and the like.

### Background Art

A general partial discharge detecting apparatus for a power transformer may be installed inside an electric power device while maintaining a predetermined insulating distance and thereby detect a partial discharge signal.

An installation type of the detecting apparatus may be classified into two types based on an installation location.

When an installation location corresponds to an upper portion of a high power transformer, the conventional partial discharge detecting apparatus may prevent leakage of insulating oil and may stably detect a partial discharge signal in a state where the insulating oil is filled. Also, the conventional partial discharge detecting apparatus may detect a partial discharge signal using a receiving unit having a wide width, such as a sensor applied to a gas insulating device. In addition, when an inspection window provided to the conventional partial discharge detecting apparatus is the same as the gas insulating device, the inspection window may be used compatibly with a partial discharge detecting apparatus of the gas insulating device.

Also, when an installation location corresponds to an inside of a drain valve of a power transformer, the conventional partial discharge detecting apparatus may not additionally include a separate inspection window and a sensor may be installed at various locations, for example, an upper portion, a lower portion, a side, and the like. In this case, the conventional partial discharge detecting apparatus is installed in a state where leakage of insulating oil is prevented using a valve and thus, may be stably mounted.

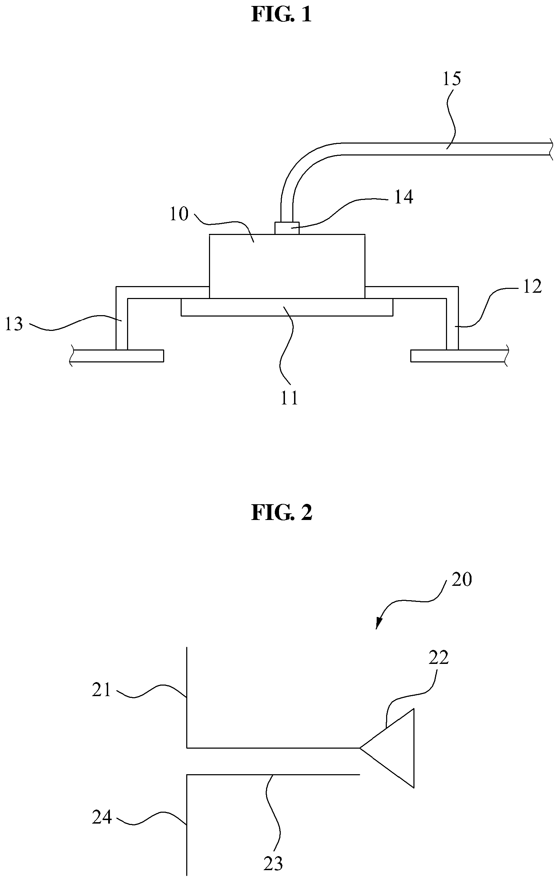

FIGS. 1 and 2 are views illustrating the conventional partial discharge detecting apparatus.

Referring to FIG. 1, a conventional partial discharge detecting apparatus 10 is installed in an upper portion of a power transformer.

The partial discharge detecting apparatus 10 may include a receiving unit 11 and inspection windows 12 and 13, and may transmit, via an N-type connector 14 and a coaxial cable 15, a signal that is detected from the power transformer.

Referring to FIG. 2, a conventional partial discharge detecting apparatus 20 is installed in a drain valve.

Here, the partial discharge detecting apparatus 20 may separately include a signal unit end 21 and a signal output end 22, and may include a receiving unit 23a connected to an input and a receiving unit 23b connected to an output in a parallel coupler form.

However, when a partial discharge detecting apparatus is installed in an upper portion of a power transformer, a sensor may not be installed. Even though a sensor may be installable, the range of partial discharge signal detection may be restricted due to a limited installation location of the sensor. Also, a partial discharge signal occurring in a lower portion of the power transformer may be attenuated due to a distance and an internal constituent element, for example, due to the affect of insulating oil, winding, and the like. Accordingly, it may be difficult to detect a signal.

On the contrary, when the partial discharge detecting apparatus is installed in a drain valve, an input and an output may be separately provided and thus, the partial discharge detecting apparatus may have a coupler function in addition to an antenna function to thereby be capable of injecting a signal and obtaining an output signal. In this case, the partial discharge detecting apparatus is installed in a drain valve capable of preventing leakage of insulating oil to thereby have a structure in which installation and separation may be readily performed.

Meanwhile, the partial discharge detecting apparatus is generally configured in a form of a circle, two semicircles having the same shape, or a long monopole and thus, may have difficult in detecting a wideband signal.

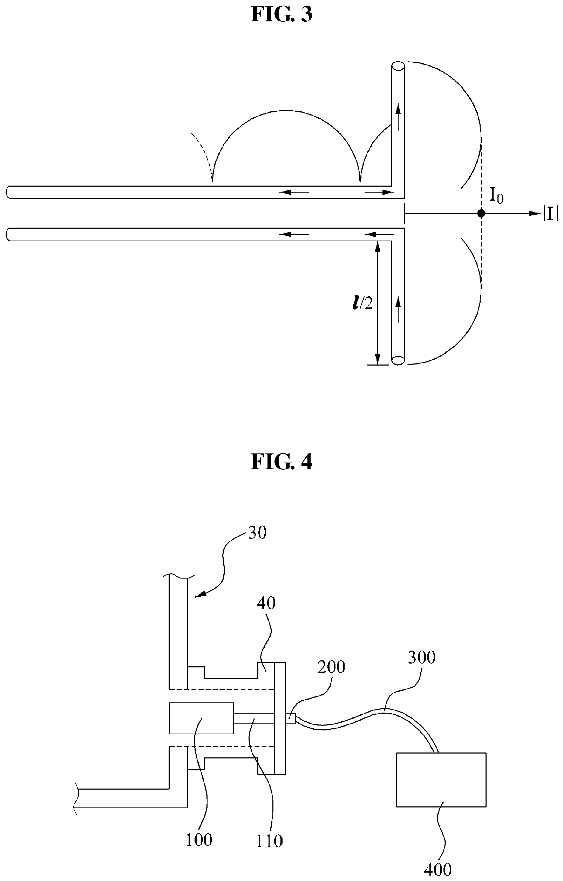

Also, the partial discharge detecting apparatus is configured in a unit shape and the same shape to be capable of having the fixed wavelength. In particular, a size of a dipole antenna structure may be determined based on a length of a wavelength shown in FIG. 3. In this case, the partial discharge detecting apparatus has a narrow bandwidth having a unit resonant frequency and thus, may have some constraints in detecting a partial discharge signal of a wide band in the case of detecting the partial discharge.

A frequency band in which the partial discharge occurs is generally 0.5 GHz to 1.5 GHz and a wideband characteristic is required to receive a signal of a wide frequency band. However, when the partial discharge detecting apparatus is configured in the unit shape and the same shape, the wavelength is physically constrained to have a wideband and thus, it may be difficult to configure the partial discharge detecting apparatus.

EP 0 699 918A1 discloses a partial discharge sensing device having a resonant element and terminal means for connecting the resonant element to a measuring equipment. The resonant element is designed to resonate at a frequency band of a UHF band spectrum generated by the partial discharge and comprises a layer-shaped dielectric substrate and two layer-shaped electrode arrangements applied to opposite surfaces of said dielectric substrate, which in particular is a printed circuit board. One of the electrode arrangements comprises a patch or a ground plane with a slot. Such a device is preferably used in a gas-insulated apparatus, in particular in a gas insulated switchgear installation.

US 2005/285604 A1 discloses a thin film detection electrode formed on an insulating substrate. The resulting detection electrodes are light-weight, and have a very high dimensional accuracy so that the number of the parts supporting the detection electrodes is small and the size of the detection electrodes becomes very small. By an increase in the dimensional accuracy of the detection electrodes, reduction in insulating properties due to awater content in an insulating gas can be measured in addition to measurement of electromagnetic wave.

US 6 333 715B1 discloses a partial discharge detector for a gas insulated apparatus having a metallic vessel, which is filled with insulation gas and accommodates therein a high voltage conductor supported by insulating members. The partial discharge detector comprises a signal receiving antenna unit formed by disposing two pieces of plate shaped conductive electrodes arranged on a common plane with a gap in a symmetric manner with respect to the gap and forming a dipole antenna in combination; a coaxial cable coupled with said signal receiving antenna unit and electrically extending outside the metallic vessel through a hermetically sealing coaxial terminal; and a measuring unit coupled with said coaxial cable.

US 2006/145705 A1 discloses a sensor for detecting partial discharges in an electrical equipment tank filled with a dielectric fluid. The sensor comprises an antenna sensitive to electromagnetic waves generated by the partial discharges, wherein the antenna is formed by first and second electrodes separated by a dielectric resonator.

US 5 726 576A discloses a microwave sensor comprising: an antenna unit which is to be placed in the vicinity of an electric apparatus and which receives a microwave signal generated by a discharge occurring in the electric apparatus; a first band-pass filter that allows a predetermined frequency of the microwave signal received by said antenna unit to pass through said filter; amplifying means for amplifying the microwave signal output from said first band-pass filter; a second band-pass filter that removes noise produced by said amplifying means; converting means for converting the microwave signal output from said second band-pass filter into a video signal; and video amplifying means for amplifying the video signal output from said converting means.

### Disclosure of Invention

### Technical Goals

Embodiments of the present invention provide an apparatus for detecting partial discharge that may detect a partial discharge signal of an electric power device, for example, a power transformer through a plurality of sub-bands.

Also, embodiments of the present invention provide an apparatus for detecting partial discharge for an electric power device that may selectively detect a partial discharge signal of a designated frequency band.

### Technical solutions

According to an aspect of the present invention, there is provided an apparatus for detecting partial discharge for an electric power device, the apparatus including: an insulator having a predetermined shape; a receiving unit including a plurality of receiving electrodes that is installed inside or outside the insulator to receive a signal of each of a plurality of sub-bands; and a connection electrode connected to a coaxial cable to transmit a signal of each of the plurality of receiving electrodes to a coaxial cable.

Further the plurality of receiving electrodes are arranged such that the plurality of receiving electrodes are disposed to face each other based on the insulator outside of the insulator or the plurality of receiving electrodes are disposed in parallel to each other based on at least one parallel maintaining electrode inside of the insulator, wherein the plurality of receiving electrodes maintain the same capacitance and have different inductances between the respective receiving electrodes, such that the plurality of receiving electrodes configures a multi-resonance circuit to form different resonant frequencies.

Here, the plurality of sub-bands may correspond to a plurality of signal bands that is divided to detect a partial discharge signal of a power transformer in entire frequency band.

Also, the receiving unit may be provided in a monopole structure.

Also, the receiving unit may include the plurality of receiving electrodes to receive a signal of each sub-band.

Also, each of the plurality of receiving electrodes may have a different wavelength to measure a signal of each sub-band.

### Effect of the Invention

According to embodiments of the present invention, a partial discharge detecting apparatus may process a frequency signal of a wideband by receiving signals of a wide frequency band via a plurality of sub-bands.

Also, according to embodiments of the present invention a partial discharge detecting apparatus may be configured to detect a signal of a desired band by selectively installing a receiving electrode having a different wavelength for each sub-band.

### Brief Description of Drawings

FIGS. 1 and 2 are views illustrating a conventional partial discharge detecting apparatus;
FIG. 3 is a view illustrating an irradiation shape of a dipole antenna;
FIG. 4 is a view illustrating a partial discharge detecting apparatus according to an embodiment of the present invention;
FIGS. 5A and 5B, and FIG. 6 are exemplary views showing a configuration of the partial discharge detecting apparatus of FIG. 4;
FIGS. 7A and 7B, and FIG. 8 are exemplary views showing a configuration of the partial discharge detecting apparatus of FIG. 4; and
FIG. 9 is a graph showing a return loss of a partial discharge detecting apparatus according to an embodiment of the present invention.

### Best Mode for Carrying Out the Invention

Hereinafter, embodiments of the present invention will be described with reference to the accompanying drawings. When it is determined detailed description related to a related known function or configuration they may make the purpose of the present invention unnecessarily ambiguous in describing the present invention, the detailed description will be omitted here. Also, terminologies used herein are defined to appropriately describe the exemplary embodiments of the present invention and thus may be changed depending on a user, the intent of an operator, or a custom. Accordingly, the terminologies must be defined based on the following overall description of this specification.

A partial discharge detecting apparatus according to an embodiment of the present invention may be applicable to a power electric device. The power electric device may correspond to a power transformer. Also, the power electric device may include a rotary device, a motor, a generator, and the like. Hereinafter, for ease of description, a description will be made using the power transformer as the power electric device applied with the partial discharge detecting apparatus.

FIG. 4 is a view illustrating a partial discharge detecting apparatus according to an embodiment of the present invention.

Referring to FIG. 4, the partial discharge detecting apparatus 100 may be installed in an upper portion of a power transformer 30 or a lower drain valve 40.

The partial discharge detecting apparatus 100 may interact with a partial discharge signal processing apparatus 400 via an N-type connector 200 and a coaxial cable 300.

To detect a partial discharge signal band, for example, 0.5 GHz to 1.5 GHz and an ultra-high frequency (UHF) band, occurring in the power transformer, the partial discharge detecting apparatus 100 may include a receiving unit to detect a signal of each of multiple sub-bands.

In particular, the receiving unit of the partial discharge detecting apparatus 100 may be provided for each of the plurality of sub-bands of the partial discharge signal band, for example, four frequency bands including a first band of 0.5 GHz to 0.75 GHz, a second band of 0.75 GHz to 1.00 GHz, a third band of 1.00 GHz to 1.25 GHz, and a fourth band of 1.25 GHz to 1.5 GHz.

Here, a structure of the receiving unit may be configured as one of a meander-line structure, a rectangular spiral structure, and a symmetrical structure in which the same electrodes face each other. Due to characteristics, the structure of the receiving unit may have a wide wavelength with a narrow area. The receiving unit may be attached on an outside of an insulator of the partial discharge detecting apparatus 100 or may be inserted into the partial discharge detecting apparatus 100.

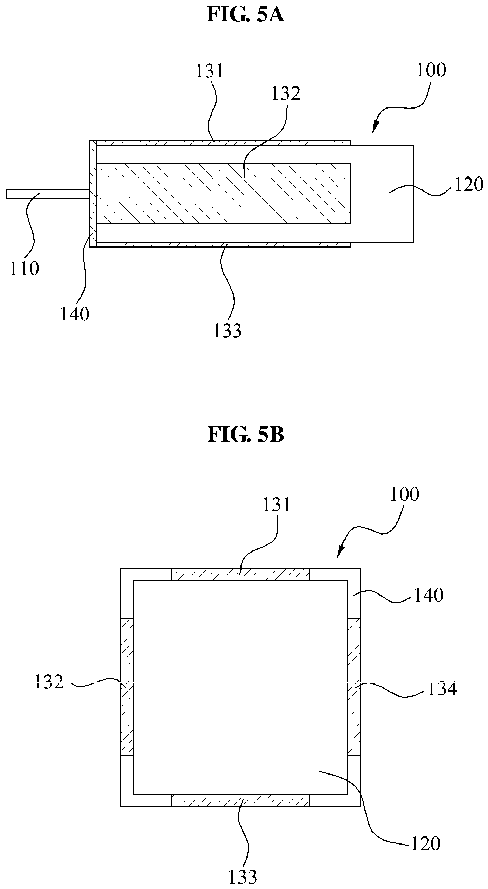

FIGS. 5A and 5B show the partial discharge detecting apparatus 100 in a case where a receiving unit is installed outside an insulator.

FIG. 5A shows a longitudinal-side view of the partial discharge detecting apparatus 100, and FIG. 5B shows a cross-sectional view of the partial discharge detecting apparatus 100.

Referring to FIGS. 5A and 5B, the partial discharge detecting apparatus 100 may include an insulator 120, a receiving unit (131 to 133), a lower electrode 140, and a connection electrode 110.

The insulator 120 may be configured in a predetermined shape, for example, an equiangular shape such as a rectangular shape or a hexagonal shape, and may be formed using acryl or epoxy solid against heat.

The receiving unit (131 to 134) may be provided inside or outside the insulator 120 to receive a signal of each of a plurality of sub-bands.

Also, the receiving unit (131 to 134) may include at least one receiving electrode, for example, receiving electrodes 131 to 134, to receive a signal of each sub-band.

The sub-band may correspond to a plurality of signal bands for detecting a partial discharge signal of the power transformer in the entire frequency band. The receiving electrodes 131 to 134 may be provided for the respective sub-bands.

Aluminum and stainless materials may be used as a material of the receiving electrodes 131 to 134 to minimize erosion occurring due to insulating oil. Each of the receiving electrodes 131 to 134 may be positioned to surround the insulator 120 and be connected to the lower electrode 140. The lower electrode 140 may be connected to the N-type connector 200 via the connection electrode 110.

In addition, each of the receiving electrodes 131 to 134 may be configured to have a 1/4 wavelength of a different band. Accordingly, the partial discharge detecting apparatus may detect signals of multiple bands.

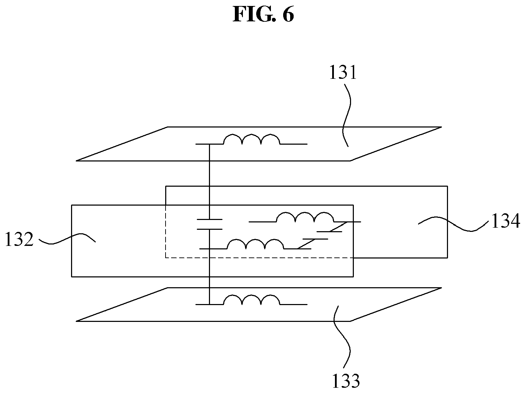

Referring to FIG. 6, since the receiving electrodes 131 to 134 have different wavelengths, different inductance may be formed.

Also, the receiving electrodes 131 to 134 may be disposed to face each other based on the insulator 120. Accordingly, capacitance may be present between predetermined receiving electrodes, for example, between the receiving electrodes 131 and 133, and between the receiving electrodes 132 and 134.

Accordingly, a predetermined parallel resonance circuit may be formed in the receiving electrodes 131 to 134 that function as a receiving unit of an antenna.

In particular, the receiving electrodes 131 to 134 have the same clearance based on the insulator 120 and thus, the same capacitance may be present. However, the entire resonance circuit may have different resonant frequencies due to inductance that forms different wavelengths.

That is, inductance of the receiving electrode 131 may form different four resonant frequencies overall. Since a parallel resonance circuit corresponds to adjacent four parallel circuits, an additional band may be formed due to interaction between adjacent circuits.

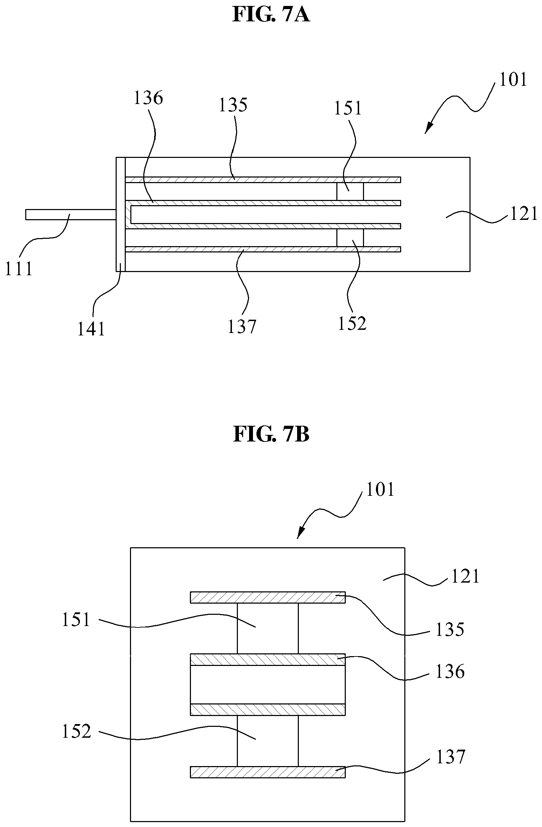

Meanwhile, FIGS. 7A and 7B show a partial discharge detecting apparatus 101 in a case where a receiving unit (135 to 137) is provided inside an insulator 121.

Referring to FIGS. 7A the partial discharge detecting apparatus 101 may include a lower electrode 141, and a connection electrode 111.

FIG. 7A shows a longitudinal-side view of the partial discharge detecting apparatus 101, and FIG. 7B shows a cross-sectional view of the partial discharge detecting apparatus 101.

Referring to FIGS. 7A and 7B, the receiving unit (135 to 137, 151, and 152) of the partial discharge detecting apparatus 101 may be provided inside the insulator 121 and be fixed to be in parallel with each other.

For this, the receiving unit (135 to 137, 151, and 152) may include a plurality of receiving electrodes 135 to 137 and at least one parallel maintaining electrode, for example, parallel maintaining electrodes 151 and 152.

The receiving electrodes 135 to 137 may be installed inside the insulator 121, and a plurality of electrode boards may be provided to be in parallel with each other in order to be capable of receiving a signal for each sub-band.

The parallel maintaining electrodes 151 and 152 may be inserted to maintain a parallel relationship between the respective receiving electrodes 135 to 137, and may be formed using the same material as the receiving electrodes 135 to 137.

Also, the insulator 121 may be configured to mold the internally installed receiving unit (135 to 137, 151, and 152).

The insulator 121 may be formed using a material having a high conductivity such as copper, aluminum, and stainless to prevent the molded receiving unit (135 to 137, 151, and 152) from being eroded due to insulating oil.

The receiving electrodes 135 to 137 may be arranged inside the insulator 121 to be in parallel with each other at predetermined intervals, and may be connected to each other via the respective connection electrodes 151 and 152.

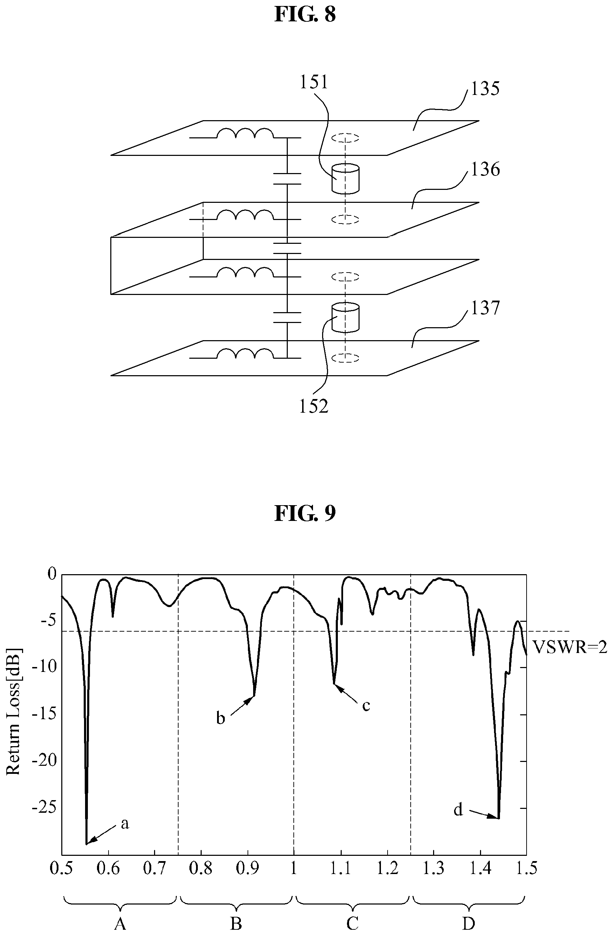

Accordingly, as shown in FIG. 8, the receiving electrodes 135 to 137 may maintain the capacitance between the respective receiving electrodes at predetermined intervals.

In particular, since the receiving electrodes, for example, an upper board of the receiving electrode 136 and the receiving electrode 135 and a lower board of the receiving electrode 136 and the receiving electrode 137 that are arranged to be in parallel with each other have different inductance, a multi-resonance circuit may be present. When a partial discharge signal is to be detected using the receiving electrode 135, a wideband detecting apparatus may be required and a multi-resonance scheme may be employed to configure the above purpose.

FIG. 9 is a graph showing a return loss of a partial discharge detecting apparatus according to an embodiment of the present invention.

Referring to FIG. 9, the return loss graph shows a test result that is obtained by connecting the partial discharge detecting apparatus 100 or 101 to a chamber for simulation test of a power transformer, and shows signals that are measured using four sub-bands A to D.

Here, each of the sub-bands A to D may be designed to be suitable for a 1/4 wavelength of a resonant frequency for each band. According to an embodiment of the present invention, four frequency bands may include a first band of 0.5 GHz to 0.75 GHz, a second band of 0.75 GHz to 1.00 GHz, a third band of 1.00 GHz to 1.25 GHz, and a fourth band of 1.25 GHz to 1.5 GHz.

Consequently, it can be known from the return loss graph that it is possible to detect resonant frequencies a to d within the respective sub-bands A to D.

In addition, the partial discharge detecting apparatus 100 or 101 may also be configured to detect a signal of only a predetermined band. For example, by providing each of the receiving electrodes 131 to 137 of the partial discharge detecting apparatus 100 or 101 for each predetermined band, the partial discharge detecting apparatus 100 or 101 may selectively detect a signal of a frequency band designated by a user or a developer, instead of detecting a signal of a consecutive frequency band.

Although a few embodiments of the present invention have been shown and described, the present invention is not limited to the described embodiments. Instead, it would be appreciated by those skilled in the art that changes may be made to these embodiments without departing from the scope of the invention which is defined by the appended claims.

## Claims

1. An apparatus (100, 101) for detecting partial discharge for an electric power device, the apparatus (100, 101) comprising:
an insulator (120) having a predetermined shape;
a receiving unit including a plurality of receiving electrodes (131 to 134, 135 to 137) that is installed inside or outside the insulator (120) to receive a signal of each of a plurality of sub-bands(A to D); and
a connection electrode (110) connectable to a coaxial cable (300) to transmit a signal of each of the plurality of receiving electrodes (131 to 134, 135 to 137) to the coaxial cable (300),
**characterized in that**,
wherein the plurality of receiving electrodes (131 to 134, 135 to 137) are arranged such that the plurality of receiving electrodes (131 to 134) are disposed to face each other based on the insulator (120) outside of the insulator (120) or the plurality of receiving electrodes (135 to 137) are disposed in parallel to each other based on at least one parallel maintaining electrode (151, 152) inside of the insulator (120), and
wherein the plurality of receiving electrodes (131 to 134, 135 to 137) maintain the same capacitance and have different inductances between the respective receiving electrodes (131 to 134, 135 to 137), such that the plurality of receiving electrodes (131 to 134, 135 to 137) configures a multi-resonance circuit to form different resonant frequencies (a to d).

2. The apparatus (100, 101) of claim 1, wherein the plurality of sub-bands (A to D) correspond to a plurality of signal bands that is divided to detect a partial discharge signal of a power transformer in a partial discharge signal band.

3. The apparatus (100, 101) of claim 1, wherein the receiving unit includes the plurality of receiving electrodes (131 to 134, 135 to 137) to receive a signal of each sub-band (A to D).

4. The apparatus (100, 101) of claim 1, wherein each of the plurality of receiving electrodes (131 to 134, 135 to 137) has a different wavelength to measure a signal of each sub-band (A to D).

5. The apparatus (100, 101) of claim 1, wherein the electric power device corresponds to a power transformer.

6. The apparatus (101) of claim 1, wherein the plurality of receiving electrodes (131 to 134, 135to 137) configures the multi-resonance circuit to form different four resonant frequencies.

## Patentansprüche

1. Vorrichtung (100, 101) zum Detektieren einer Teilentladung für eine Stromversorgungsvorrichtung, wobei die Vorrichtung (100, 101) aufweist:
einen Isolator (120) mit einer vorbestimmten Form;
eine Empfangseinheit, aufweisend eine Mehrzahl von Empfangselektroden (131 bis 134, 135 bis 137), die innerhalb oder außerhalb des Isolators (120) installiert sind, um ein Signal von jedem einer Mehrzahl von Teilbändern (A bis D) zu empfangen; und
eine Verbindungselektrode (110), die mit einem Koaxialkabel (300) verbindbar ist, um ein Signal von jeder der Mehrzahl von Empfangselektroden (131 bis 134, 135 bis 137) an das Koaxialkabel (300) zu übermitteln,
**dadurch gekennzeichnet, dass**,
wobei die Mehrzahl von Empfangselektroden (131 bis 134, 135 bis 137) derart angeordnet ist, dass die Mehrzahl von Empfangselektroden (131 bis 134) basierend auf dem Isolator (120) angeordnet ist, um einander außerhalb des Isolators (120) zugewandt zu sein, oder die Mehrzahl von Empfangselektroden (135 bis 137) basierend auf mindestens einer parallelen Halteelektrode (151, 152) parallel zu einander innerhalb des Isolators (120) angeordnet ist, und
wobei die Mehrzahl von Empfangselektroden (131 bis 134, 135 bis 137) die gleiche Kapazität beibehält und unterschiedliche Induktivitäten zwischen den jeweiligen Empfangselektroden (131 bis 134, 135 bis 137) hat, so dass die Mehrzahl von Empfangselektroden (131 bis 134, 135 bis 137) einen Mehrfachresonanzkreis konfiguriert, um verschiedene Resonanzfrequenzen (a bis d) zu bilden.

2. Vorrichtung (100, 101) gemäß Anspruch 1, wobei die Mehrzahl von Teilbändern (A bis D) mit einer Mehrzahl von Signalbändern korrespondiert, die unterteilt ist, um ein Teilentladungssignal eines Leistungstransformators in einem Teilentladungssignalband zu detektieren.

3. Vorrichtung (100, 101) gemäß Anspruch 1, wobei die Empfangseinheit die Mehrzahl von Empfangselektroden (131 bis 134, 135 bis 137) aufweist, um ein Signal jedes Teilbandes (A bis D) zu empfangen.

4. Vorrichtung (100, 101) gemäß Anspruch 1, wobei jede aus der Mehrzahl von Empfangselektroden (131 bis 134, 135 bis 137) eine unterschiedliche Wellenlänge zum Messen eines Signals jedes Teilbandes (A bis D) aufweist.

5. Vorrichtung (100, 101) gemäß Anspruch 1, wobei die Stromversorgungsvorrichtung mit einem Leistungstransformator korrespondiert.

6. Vorrichtung (101) gemäß Anspruch 1, wobei die Mehrzahl von Empfangselektroden (131 bis 134, 135 bis 137) den Mehrfachresonanzkreis konfiguriert, um vier verschiedene Resonanzfrequenzen zu bilden.

## Revendications

1. Appareil (100, 101) pour la détection d'une décharge partielle pour un dispositif d'alimentation électrique, cet appareil (100, 101) comprenant :
un isolateur (120) ayant une forme prédéterminée ;
une unité de réception comprenant une pluralité d'électrodes de réception (131 à 134, 135 à 137) qui sont installées à l'intérieur ou à l'extérieur de l'isolateur (120) pour recevoir un signal de chacune d'une pluralité de sous-bandes (A à D) ; et
une électrode de connexion (110) pouvant être connectée à un câble coaxial (300) pour transmettre un signal de chacune de la pluralité d'électrodes de réception (131 à 134, 135 à 137) au câble coaxial (300),
**caractérisé en ce que**
la pluralité d'électrodes de réception (131 à 134, 135 à 137) sont disposées de façon à ce que la pluralité d'électrodes de réception (131 à 134) sont disposées de façon à se faire face entre elles sur la base de l'isolateur (120) à l'extérieur de l'isolateur (120) ou la pluralité d'électrodes de réception (135 à 137) sont disposées parallèlement entre elles sur la base d'au moins une électrode de maintien parallèle (151, 152) à l'intérieur de l'isolateur (120) et
la pluralité d'électrodes de réception (131 à 134, 135 à 137) maintiennent la même capacité et présentent des inductances différentes entre les électrodes de réception (131 à 134, 135 à 137) respectives, de façon à ce que la pluralité d'électrodes de réception (131 à 134, 135 à 137) constituent un circuit à résonances multiples pour former différentes fréquences de résonance (a à d).

2. Appareil (100, 101) selon la revendication 1, dans lequel la pluralité de sous-bandes (A à D) correspondent à une pluralité de bandes de signaux qui sont divisées afin de détecter un signal de décharge partielle d'un transformateur de puissance dans une bande de signal de décharge partielle.

3. Appareil (100, 101) selon la revendication 1, dans lequel l'unité de réception comprend la pluralité d'électrodes de réception (131 à 134, 135 à 137) afin de recevoir un signal de chaque sous-bande (A à D).

4. Appareil (100, 101) selon la revendication 1, dans lequel chacune de la pluralité d'électrodes de réception (131 à 134, 135 à 137) présente une longueur d'onde différente pour mesurer un signal de chaque sous-bande (A à D).

5. Appareil (100, 101) selon la revendication 1, dans lequel le dispositif d'alimentation électrique correspond à un transformateur de puissance.

6. Appareil (101) selon la revendication 1, dans lequel la pluralité d'électrodes de réception (131 à 134, 135 à 137) constituent le circuit à résonances multiples pour former quatre fréquences de résonance différentes.
